# EUROPEAN PATENT SPECIFICATION

(11) **EP 0 697 732 B1**
(45) Date of publication and mention of the grant of the patent: **17.03.2004**
(21) Application number: 95305482.2
(22) Date of filing: 07.08.1995
(51) Int. Cl.: H01L 25/065, H01L 25/18, H01L 25/07

(54) **Driving circuit module**
Steuerschaltungsmodul
Module à circuit de commande

(30) Priority: 10.08.1994 JP 18797694
(43) Date of publication of application: 21.02.1996
(73) Proprietor: FUJI ELECTRIC CO. LTD., Kawasaki 210 (JP)
(72) Inventor: Terasawa, Noriho, Kawasaki-ku, Kawasaki 210 (JP)
(74) Representative: Bridge-Butler, Alan James

(56) References cited:
- EP-A- 0 463 589
- US-A- 4 862 344
- US-A- 5 170 337
- US-A- 5 313 150
- PATENT ABSTRACTS OF JAPAN vol. 011, no. 187 (E-516), 16 June 1987 & JP 62 016554 A (SHARP CORP), 24 January 1987,
- PATENT ABSTRACTS OF JAPAN vol. 011, no. 187 (E-516), 16 June 1987 & JP 62 016553 A (SHARP CORP), 24 January 1987,
- SHIGEKANE, H. ET AL: "High Power Transistor Modules with Intelligent Functions" PROCEEDINGS OF 1990 INTERNATIONAL SYMPOSIUM ON POWER SEMICONDUCTOR DEVICES & ICS, 4 - 6 April 1990, TOKYO, JAPAN, pages 150-155, XP002058955
- PATENT ABSTRACTS OF JAPAN vol. 016, no. 478 (E-1274), 5 October 1992 & JP 04 171754 A (MITSUBISHI ELECTRIC CORP), 18 June 1992,
- PATENT ABSTRACTS OF JAPAN vol. 095, no. 003, 28 April 1995 & JP 06 334286 A (DENKI KAGAKU KOGYO KK), 2 December 1994,

## Description

The present invention relates to driving circuit modules and particularly concerns unitary devices which have a main circuit including a plurality of power semiconductor elements connected in a bridge circuit, for driving inverters etc.

Power converting apparatus such as inverters and the like are widely used for driving motors etc. Usually, the driving circuit devices for driving power converting apparatus are constructed as three-phase or two-phase bridge circuits, and comprise semiconductor power elements such as insulated gate bipolar transistors, bipolar transistors, field effect transistors, etc. In practice, it is quite convenient to incorporate the semiconductor power elements integrally with related elements such as free-wheeling diodes etc. into a module. The semiconductor elements from which the module is made up may be individual elements, mounted individually inside a package. However, it is far more effective for reducing the size and cost of the driving circuit modules to mount them as constituent semiconductor element chips on a base of the module, and then, mount the base in a package case to form a whole driving circuit module.

The conventional driving circuit modules have a metal base plate made of copper or the like which shows high thermal conductivity. Necessary numbers of electrode plates made of copper or the like are held on the metal base plate through insulator plate made of ceramic etc. which shows high thermal resistance. Chips of the constituent elements such as transistors, annexed diodes, etc., the constituents of the module, are mounted on and bonded with the electrode plates. Output and input terminals are connected with the electrode plates through conductors. The thus assembled driving circuit device is covered with or fitted into a moulded resin case. A resin is injected into the space between the case and the base plate, and hardened to form a solid unitary module. As is well known, the driving circuit modules are generally used with their base plates fixed to an aluminium heat sink or radiator in tight thermal contact, and with their cases mounted on an inverter etc.

It is necessary for using the driving circuit modules in various applications to incorporate a control circuit with the driving circuit module and to command detailed on-off operations of each semiconductor element constituting the bridge circuit, depending on the application and the state of the load. Therefore, it has been required for simplifying the overall structure of the system including the control circuit to construct the driving circuit as an intelligent module which executes at least some functions which the control circuit does.

Since the control circuits may be electronic circuits which consume little electrical power, the recent circuit integration techniques facilitate integrating the control circuits into a very small chip, and mounting the chip on a module, although the control circuit may be complicated. The most serious problem is that the control signal wiring is so complicated that it is necessary to lead out extra control signal lines for providing multi-purpose driving circuit modules.

The complexity of the wiring may be avoided by using wiring boards. But, the wiring board increases the size of the module to elongate the wiring length in the conventional module structures. The elongated wiring length increases the cost of compensating for the wiring inductance by installing one or more capacitors. Reduction of the space between the wiring conductors tends to cause malfunction by mutual interference of the control signals. Though the space may be reduced by using the base plate as the wiring board, it becomes very difficult to secure the withstand voltage between the high voltage power semiconductor elements and the control circuit.

In view of the foregoing, it is an object of the present invention to provide a driving circuit module, into which the control function is incorporated, and which facilitates shortening the internal wiring length of the control signal lines to suppress the increase of the size and cost of the module as much as possible.

US Patent No. 5,313,150 discloses a driving circuit module which includes semiconductor elements connected in a bridge circuit having upper and lower arms connected between a pair of power supply points. The semiconductor elements are all controlled by a control circuit and are arranged on a square base plate. There is no attempt to make maximum use of the base plate area or to minimise connection lengths between components.

According to the present invention a driving circuit module comprises a driving circuit device having a main circuit which includes semiconductor elements connected in a bridge circuit having upper and lower arms connected between a pair of power supply points; control input circuits for controlling the respective semiconductor elements; a rectangular base plate; input and output terminals of the main circuit connected with the corresponding semiconductor elements by respective conductors; and, control input terminals connected to their respective control input circuits via a wiring board or boards characterised in that chips are provided for the semiconductor elements on the upper arms of the bridge circuit and chips are provided for the semiconductor elements on the lower arm of the bridge circuit and are each arranged in a row parallel with two opposed sides of the rectangular base, rows of chips of the control input circuits for the upper and lower arms of the bridge circuit are provided, each circuit being located in line with its respective semiconductor element in a direction normal to the row of semiconductor elements, and in which the input terminals and output terminals are arranged along one side or parallel sides of the base plate and the control input terminals are arranged along one or more sides of the base plate not employed for the input and output terminals.

In a preferred embodiment the rectangular base plate has two long and two shorter sides respective rows of chips for the semiconductor elements of the upper and lower arms being arranged in a single line.

With this arrangement the input and output terminals can be arranged along a long side of the base plate adjacent the semiconductor elements and the control input terminals are arranged along the other long side.

In another preferred embodiment the rectangular base plate can be square and the row of chips for the semiconductor elements in the upper arm of the bridge circuit are arranged in a row parallel with the row of chips for the semiconductor elements in the lower arm of the bridge circuit, said rows being parallel with two of the sides of the square base plate.

In this construction the input terminals and output terminals can be arranged on opposite parallel sides of the base plate normal to the sides with which the rows semiconductor elements are parallel, and the central input terminals are located along the other two sides of the square and parallel with the rows of semiconductor elements and adjacent the rows of chips of the central input circuits.

It is preferable to mount the chips of the control input circuits on exclusive electrode plates disposed on the base plate separately from the chips of the semiconductor elements, and connect the control input circuits with their corresponding semiconductor elements.

It is preferable for avoiding complicated wiring between the input and output terminals of the main circuit and the semiconductor elements to arrange the semiconductor elements constituting the upper arm of the main circuit in a first area, and the semiconductor elements constituting the lower arm of the main circuit in a second area separated from the first area.

It is also preferable for facilitating the mounting of the semiconductor elements to provide a first common electrode plate; first individual electrode plates; a second common electrode plate; and second individual electrode plates, to arrange the semiconductor elements constituting the upper arm of the main circuit on the first common electrode plate, connect the upper arm semiconductor elements with the respective first individual electrode plates, and to arrange the semiconductor elements constituting the lower arm of the main circuit on the respective second individual electrode plates, and connect the lower arm semiconductor elements with the second common electrode plate.

It is preferable to connect one of the input terminals corresponding to the power supply points with the first common electrode plate, the other input terminal with the second common electrode plate, and the output terminals in common with the respective first individual electrode plates and the respective second individual electrode plates.

It is preferable to form the input terminals and the output terminals at the ends of the respective conductors for connecting the input terminals and the output terminals with the corresponding electrode plates.

The control input terminals preferably include power supply terminals led out from the control input circuits for facilitating various applications of the module.

It is preferable to fit a case to the base plate, the case being shaped with a frame having a window corresponding to the mounting area of the base plate, in which the semiconductor elements and the control input terminals are mounted.

It is advantageous, to obtain a solid and unitary module, to inject a liquid resin between the case and the base plate, and harden the liquid resin.

The present invention provides an intelligent driving circuit module by adopting the following measures. Each of the semiconductor elements constituting the bridge circuit of the driving circuit is provided with an exclusive control input circuit which directly controls the pairing semiconductor element exclusively. The control input circuits are mounted in the vicinity of their pairing semiconductor elements. The control input circuits are arranged in the periphery of the mounting area of the base plate, and the control input terminals are arranged in the periphery of the base plate and in the vicinity of the corresponding control input circuits so that a small wiring board may be used which connects the control input terminals and the control input circuits via the shortest path. Thus, the dimensions of the module are reduced by the adoption of the small wiring board. Also, the cost of the module is reduced since the shortened wiring length allows the elimination of the conventional capacitor for compensating the wiring inductance.

Briefly stated, in a first embodiment, the chips of the semiconductor elements are mounted in a row extending parallel with the long sides of the rectangular base plate in a first embodiment. The chips of the control input circuits are displaced from the semiconductor elements in the direction of the short sides of the base plate and are mounted in a row extending parallel with the long sides of the base plate. The control input terminals are arranged on the long side of the base plate adjacent the row of control input circuits. In a second embodiment, the chips of the semiconductor elements and the control input circuits are divided and mounted in opposed rows facing one another, the rows extending parallel with a pair of sides of a square base plate. The control input circuits are placed adjacent their corresponding semiconductor elements, but displaced toward the periphery of the mounting area of the base plate. The control input terminals are also divided and arranged on the sides of the base plate along which the corresponding control input circuits are arranged. In the embodiments shown, the control input circuits are connected with the control input terminals via a wiring board or wiring boards.

In the first embodiment, the input and output terminals of the main circuit are arranged along a long side of the base plate, parallel to the row in which the semiconductor elements are mounted. In the second embodiment, the input and output terminals of the main circuit are arranged on a pair of sides of the square base plate opposed to one another and extending perpendicularly to the rows of semiconductor elements. In both embodiments, the input and output terminals are connected easily with the semiconductor elements via conductors extending above the chip mounting area of the base plate without crossing the other conductors.

By the above described configurations of the present invention, the input and output terminals, the wiring board or boards, and control input terminals are arranged by effectively utilising the peripheral space of the chip mounting area of the base plate. The first embodiment of the present invention reduces the module area to a minimum by arranging the input and output terminals, the wiring boards, and control input terminals on the long sides of the rectangular base plate. The second embodiment of the present invention reduces the module area to a minimum by distributing the input and output terminals, the wiring boards, and control input terminals to the four sides of the square base plate. The control input circuit as the key element of the present intelligent driving circuit module may be integrated into a small chip much smaller than the semiconductor element chip. Thus, the chip mounting area of the module may increase by 10% at most even when the control function is distributed to a plurality of control input circuits disposed so as to correspond to the semiconductor elements.

The present invention will now be explained in detail with reference to the accompanying drawings, in which the preferred embodiments of the present invention are illustrated. In the Figures:
Figure 1(a) is a top plan view showing the mounted state of the chips of a first embodiment of the present invention;
Figure 1(b) is a top plan view showing the terminal arrangement and connections of the first embodiment of the present invention;
Figure 1(c) is a top plan view showing the module mounted inside the case of the first embodiment of the present invention;
Figure 2(a) is a top plan view showing the mounted state of the chips of a second embodiment of the present invention;
Figure 2(b) is a top plan view showing the terminal arrangement and connections of the second embodiment of the present invention;
Figure 2(c) is a top plan view showing the module mounted inside the case of the second embodiment of the present invention; and
Figure 3 is a circuit diagram showing the driving circuit having a bridge connection and mounted on the module of the first embodiment or the second embodiment.

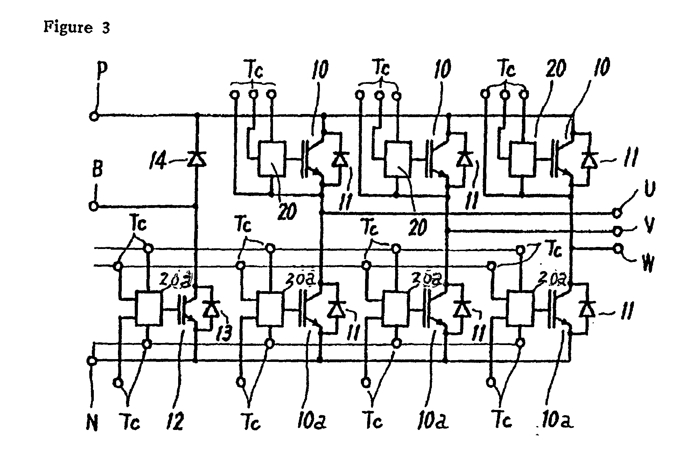

Referring now to Figure 3, the first and second embodiments will now be explained to facilitate understanding.

Figure 3 shows a three-phase bridge circuit corresponding to a driving circuit of an inverter for driving a three-phase motor. The circuit of Figure 3 includes a braking circuit for absorbing the energy stored in the inductance on the side of the load such as a motor. A semiconductor elements 10 constituting the bridge circuit of Figure 3 are insulated gate bipolar transistors. As usual, each upper arm semiconductor element 10 is connected in series with a pairing lower arm semiconductor element 10a. Three pairs of the upper and lower arm semiconductor elements are connected in parallel between a positive input terminal P and a negative input terminal N of a DC power supply. The collector of each of the upper arm semiconductor elements 10 is connected with the positive input terminal P, while the emitter of each of the lower arm semiconductor elements 10a is connected with the negative input terminal N. The emitter of each of the upper arm semiconductor elements 10 is connected with the collector of its respective lower arm semiconductor element 10a. Three output terminals U, V, and V are lead out individually from the connection points between the respective pairs of semiconductor elements of the upper and lower arms. A free wheeling diode 11 is connected in reverse parallel with each semiconductor element 10.

The present invention connects a control input circuit 20, 20a shown by a rectangular block to the gate of each semiconductor element 10a. The control input circuit 20 or 20a includes a gate driving circuit which directly drives the semiconductor element 10a. A pair of power supply terminals Tc and a control signal terminal Tc are led out from each control input circuit 20 located on the upper arm. A pair of power supply terminals Tc and two control signal terminals Tc are led out from each control input circuit 20a located on the lower arm. For increasing the freedom of the driving circuit module for various applications, three control input terminals Tc are independently led out from the upper arm control input circuit 20, and four control input terminals Tc are independently led out from the lower arm control input circuit 20a in Figure 3. As shown in the figure, connections are made to the power supply terminals Tc independently led out of the control input circuits 20 outside the module as shown by the fine lines in the Figure, except that the negative power supply terminals of the control input circuits 20a located on the lower arm side are connected inside the module with the emitters of the corresponding semiconductor elements 10a.

A semiconductor element 12 with a small capacity shown on the left hand side of the Figure 3 is disposed for braking as described earlier. A diode 13 is connected in reverse parallel with the semiconductor element 12. An emitter of the semiconductor element 12 is connected with the negative input terminal N. A braking terminal B is led out from a collector of the semiconductor element 12. The semiconductor element 12 is provided with a control input circuit 20a having four control input terminals Tc. When the semiconductor element 12 is turned on by the gate control of the corresponding control input circuit 20a, a current flows through a braking resistor (not shown) connected between the positive input terminal P and the braking terminal B. In association with this current flow, the stored energy is absorbed from the load side via the diodes 11 of the bridge circuit. A diode 14 is fixed between the terminals P and B for free wheeling when a reverse current is caused during the baking operation.

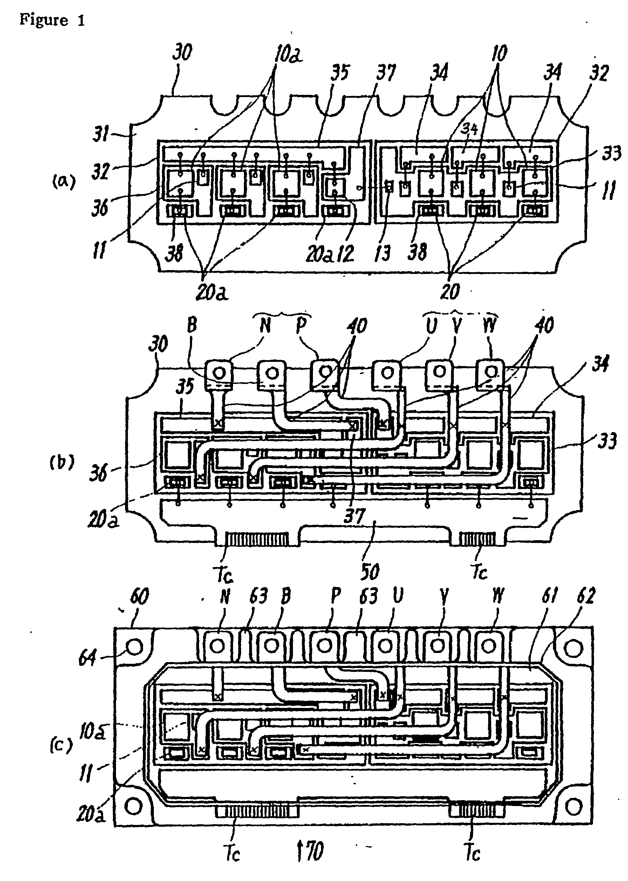

Referring now to Figures 1(a), 1(b) and 1(c), Figure 1(a) shows the mounted state of the chips. Figure 1(b) shows the terminal connections, and Figure 1(c) the module mounted inside a case. As shown in Figure 1(a), a base 30 is formed with a rectangular shape.
Semicircular cutouts are formed on a long side of the base 30 to accept the input and output terminals. Quadrant-shaped cutouts are formed at the four corners of the base 30 for fixing the module. The base 30 comprise a thick metal plate made of copper or the like, which shows high thermal conductivity. In Figure 1(a), two rectangular ceramic insulator plates 32 are arranged side by side with their long sides aligned in the central part of the base 30, and fixed securely to the base 30, as for example by brazing or by soldering. The insulator plate 32 is made of alumina or the like. Metal electrode plates with various shapes are arranged in the predetermined locations on the insulator plate 32. The metal electrode plates are made of copper or the like, which shows high electrical conductivity. The metal electrode plates are fixed to the insulator plate 32 with their upper faces positioned on the same level.

The upper arm of the bridge circuit is mounted on the insulator plate 32 shown on the right hand side of the Figure. This insulator plate 32 supports three semiconductor elements 10, three diodes 11, a common electrode plate 33 common to the semiconductor elements 10 and the diodes 11, and three individual electrode plates 34.

The lower arm of the bridge circuit is mounted on the insulator plate 32 shown on the left hand side of the Figure. The lower arm insulator plate 32 supports a common electrode plate 35 and three individual electrode plates 37. In addition, the lower arm insulator plate 32 supports a second electrode plate 37 for the braking semiconductor elements 12, and electrode plates 38 for four control input circuits 20a including the one for braking.

According to the present invention, it is preferable to mount the chips of the semiconductor elements and the respective control input circuits in close proximity. Specifically, the semiconductor elements 10 and 10a are aligned in a row extending parallel with the long sides of the base 30, and the corresponding control input circuits 20 are positioned adjacent their corresponding semiconductor elements 10 in a row extending parallel with the long sides of the base and each is displaced in line with its respective semiconductor element in the direction of the short sides of the base 30 from the row of semiconductor elements 10, as shown in Figure 1(a), that is, normal to the row of semiconductor elements.

Due to this arrangement, three semiconductor elements 10 of the upper arm are aligned in the lateral direction of Figure 1(a), and are soldered to the common electrode plate 33. Since the semiconductor element 10 is a vertical power semiconductor element having its collector on the undersurface of the chip, the collector is connected with the common electrode plate 33 at the same time as the semiconductor element 10 is mounted on the common electrode plate 33. Therefore, the mounting of the semiconductor element 10 is completed by connecting its emitter with the individual electrode plate 34, and its gate with the control input circuit 20 by wire bonding. It is preferable to mount the diodes 11 in the neighbourhood of their corresponding semiconductor elements 10. The diodes 11 are connected with the respective individual electrode plates 34 by wire bonding after the diodes 11 are mounted on and fixed to the common electrode plate 33. It is preferable to insert the electrode plates 38 for the control input circuits 20 in the recesses formed in the periphery of the common electrode 33. An integrated circuit of the control input circuit 20 may be incorporated into the chip of the semiconductor element 10, since the semiconductor element 10, although designed for the power application, very often has repeated fine unit structures built in by the techniques of manufacturing the highly integrated circuits.

Three semiconductor elements 10a of the lower arm are aligned along the long side of the base 30, and the respective diodes 11 are disposed in the neighbourhood of the corresponding semiconductor element. On the lower arm side, the chips of each semiconductor element 10 and the corresponding diode 11 are mounted on the individual electrode 36, and are connected with the common electrode plate 35 by wire bonding. The braking semiconductor element 12 is mounted on the electrode plate 37 and bonded to the common electrode plate 35. The diode 13 which the semiconductor element 12 accompanies is mounted on the common electrode plate 33 on the upper arm side and connected with the electrode plate 37 on the lower arm side by wire bonding.

On the lower arm side too, the control input circuits 20a are mounted on the respective electrode plates 38 disposed immediately below (as seen in the Figure) the individual electrode plates 36 or plate 37 so that the control input circuits 20 may be positioned in the closest proximity to their corresponding semiconductor elements 10 and 12. The control input circuits 20 are connected with the corresponding semiconductor elements 10 and 12 by wire bonding. The upper arm common electrode plate 33 and the lower arm individual electrode plates 36 on which the chips are mounted in the vertical centre of the insulator plates 32. The electrode plates 38 for mounting the chips of the control input circuits 20a are arranged in the lower parts of their respective insulator plates 32, and the upper arm individual electrode plates 34 and the lower arm common electrode plate 35, to which no chips are mounted, are arranged in the upper parts of their respective insulator plates 32. By this arrangement, the chip mounting area of the base 30 can be confined in a small area without leaving any unused area.

Thus it will be seen that the semiconductor elements 10a of the lower arm are also arranged in a row parallel to the long sides of the plate 30 and each of the corresponding control input circuits 20a is arranged in line with its respective semiconductor element 10a in a direction normal to the row of semiconductor elements 10a. It will also be seen that the semiconductor elements 10 of the upper arm and the semiconductor elements 10a of the lower arm are arranged in a single line.

Referring now to Figure 1(b), Figure 1(b) shows the terminals of the module led out from the chip mounting area. The input and output terminals of the main circuit of the first embodiment are aligned as shown in the Figure on the long side of the base 30 opposite to the long side near which the control input circuits 20a are arranged. It is preferable for leading out the terminal to use a copper conductor 40 on one end of which the terminal is formed. The conductor 40 is connected with a predetermined electrode plate located in the chip mounting area by soldering. More specifically, the conductors 40 for the input terminals P and N are connected with the common electrode plates 33 and 35, respectively, at the positions indicated in Figure 1(b) by X symbols. The conductor 40 for the braking terminal B is connected with the electrode plate 37 located on the lower arm side. Each of the output terminals U, V, and W is connected via a conductor 40 to the corresponding individual electrode plate 34 on the upper arm side and to the corresponding individual electrode plate 36 on the lower arm side. Thus, the input and output terminals of the main circuit are connected by effectively using only the spaces on and above the chip mounting area.

In the first embodiment, the control input terminals Tc are aligned on the long side of the base 30 on the side on which the control input circuits 20 and 20a are arranged. The control input terminals Tc are connected with the control input circuits 20 and 20a via a wiring board 50. In practice, it is preferable to dispose the control input terminals Tc in a part of the wiring board 50 as shown in Figure 1(b). Since all the control input circuits 20 and 20a are aligned, the control input circuits 20 and 20a are connected easily with the control input terminals Tc via the wiring board 50 and bonding wires. Since the control input circuits 20 and 20a and the control input terminals Tc are arranged on the same side of the base 30, the wiring board 50 may be a small one, and its internal wiring conductor lengths may be short. In the illustrated example, the control input terminals Tc are divided into two groups for the upper arm and the lower arm so as to shorten the wiring conductor lengths of the wiring board 50 as much as possible. If necessary, an integrated circuit for controlling the entire driving circuit device in addition to the control by the control input circuits 20 and 20a may be mounted on the wiring board 50.

Referring now to Figure 1(c), Figure 1(c) shows an almost completed module 70 in which the base 30 is fitted to a case 60. The case 60 is a moulded resin frame which has a window 61 substantially corresponding to the chip mounting area of the base 30. The case 60 has also a sheath 62 which surrounds the window 61. Separation walls 63 protrude from the sheath 62 for separating the input and output terminals from each other. Fixing holes 64 are disposed in the four corners of the case 60. Since recesses are disposed on the back side of the case 60 so that the case 60 may fit in with the outline of the base 30, the case 60 and the base 30 can be assembled as shown in the figure simply by fitting the case 60 and the base 30 to one another. Though Figure 1(b) was explained prior to Figure 1(c) for the sake of clearer understanding, it is preferable to fit the case 60 to the base 30 of Figure 1(a), and to complete the assembly as shown in Fig 1(c) by arranging the terminals and connecting them as explained with reference to Figure 1(b). Finally, a very solid driving circuit module 70 is obtained by injecting a liquid resin into the case 60 to fill the window 61, and hardening the liquid resin.

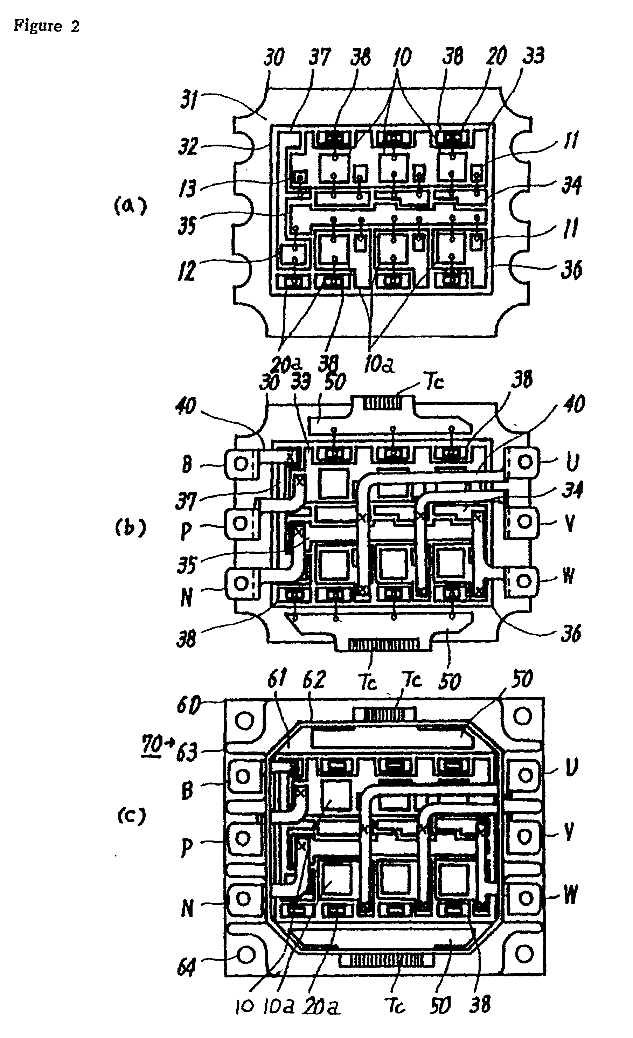

Figures 2(a), 2(b) and 2(c) show top plan views of the second embodiment of the present invention. In Figures 2(a), 2(b) and 2(c), the same parts with those of Figures 1(a), 1(b) and 1(c) are designated with the same reference numerals or symbols and their duplicated explanation will be omitted. Referring now to Figure 2(a), a base 30 of the second embodiment has an almost square main body 31. An almost square insulator plate 32 formed corresponding to the square main body 31 is bonded with the square main body 31 of the base 30. Chips of semiconductor elements 10 and 10a are mounted in two rows extending in parallel with a pair of opposed facing sides of the base 30 as shown in the figure. Control input circuits 20 and 20a are arranged on the upper side or the lower side of their corresponding semiconductor elements 10.

The top half of the insulator plate 32 (as seen in the Figures) corresponds to the upper arm side, and the bottom half the lower arm side. Chips of three semiconductor elements 10 and associated diodes 11 are mounted on a common electrode plate 33 on the upper arm side. Chips of three semiconductor elements and associated diodes 11 are mounted on respective individual electrode plates 36 on the lower arm side. Individual electrode plates 34 of the upper arm side and a common electrode plate 35 of the lower arm side are arranged between the common electrode plate 33 and the individual electrode plates 36. The semiconductor elements 10a of the upper arm are connected with their respective individual electrode plates 34 by wire bonding, and the semiconductor elements 10 of the lower arm with the common electrode plate 35 by wire bonding. A long electrode plate 37 is arranged along the left side of the insulator plate 32. A semiconductor element 12 for braking is mounted on the bottom end of the electrode plate 37, and connected with the electrode plate 35 by wire bonding. A diode 13 associated with the semiconductor element 12 is mounted on the left end of the common electrode plate 33, and connected with the central part of the electrode plate 37 by wire bonding. Control input circuits 20 of the upper arm are mounted on respective individual electrode plates 38 arranged immediately above the common electrode plate 33 and connected with the corresponding semiconductor elements 10 by wire bonding. Control input circuits 20a of the lower arm are mounted on individual electrode plates 38 arranged immediately below the individual electrode plates 36 and the electrode plate 37, and connected with the corresponding semiconductor elements 10 and 12 by wire bonding.

As shown in Figure 2(b), braking terminal B and input terminals P and N of the main circuit are arranged in a row on the left side of the base 30, extending perpendicularly to the alignments of the semiconductor elements 10 and 10a of the upper and lower arms. Output terminals U, V and W of the main circuit are arranged in a row on the right side of the base 30, extending perpendicularly to the alignments of the semiconductor elements 10 and 10a in the upper and lower arms.

Control input terminals Tc are divided and arranged on the sides of the base 30 extending in parallel with the alignments of the semiconductor elements 10 and 10a. Since the connection of the input and output terminals with the chip mounting area via conductors 40 is done in the similar manner as in the first embodiment, its explanation is omitted. Two wiring boards 50 are used in the second embodiment for mounting the control input terminals Tc. One of the wiring boards 50 is arranged in the upper part of the base 30, and the other one in the lower part of the base 30. The control input terminals Tc are constructed as a part of the wiring boards 50. The wiring boards 50 are small enough to shorten the internal wiring length as in the first embodiment. Since the as assembled module shown in Figure 2(c) is almost same as that shown in Figure 1(c) except the module is square in the second embodiment, the explanation referring to Figure 2(c) is omitted. The second embodiment is more preferable to the first embodiment, since the module 70 is shaped as a square which facilitates further reducing the size of the module in comparison with the rectangular module of the first embodiment.

Though the embodiments of the present invention have been explained using the insulated gate bipolar transistor as the semiconductor element 10, 10a it is to be clearly understood that the present invention is applicable to driving circuit devices incorporating bipolar transistors, field effect transistors, etc. It is also to be understood that the present invention is applicable to driving circuit devices having a two-phase bridge circuit configuration.

As explained above, the present invention provides a driving circuit device, having a bridge connection, with a circuit configuration which provides each power semiconductor element with a control input circuit. In the first embodiment, the chips of the semiconductor elements are mounted along the long side of the rectangular base plate. The chips of the control input circuits are displaced from the semiconductor elements along the short sides of the base plate and mounted along the long side of the base plate. The input and output terminals of the main circuit are arranged on one of the sides of the base plate along which the semiconductor elements are aligned. The control input terminals are arranged on the other side of the base plate, along which the control input circuits are aligned.

In the second embodiment, the chips of the semiconductor elements and the control input circuits are divided and mounted along a pair of the sides of the square base plate oppositely facing one another. The control input circuits are mounted on the peripheral side of the corresponding semiconductor elements. The control input terminals are also divided and arranged on the side along the control input circuits are arranged. The input and output terminals of the main circuit are arranged on the other pair of the sides of the square base plate opposed facing to one another. The input and output terminals are connected with the semiconductor elements via conductors. And, the control input circuits are connected with the control input terminals via wiring boards.

The present invention that adopts the above described module structures shows the following effects.

The chips of the control input circuits are mounted on the periphery of the chip mounting area of the base, and the control input terminals are arranged in the periphery of the base in close proximity to the corresponding control input circuits. Thus, the control signal wiring between the control input circuits and their respective terminals is shortened to a length short enough to eliminate the conventional capacitor for compensating the wiring inductance. This makes it possible to adopt a small wiring board for the control signal wiring. As a result, the cost and the size of the module are reduced.

The control input circuit with small chip size is enough only to directly control the corresponding power semiconductor element. And the control input circuits are located in close proximity to the pairing semiconductor elements. Thus, the increase of the chip mount area by the incorporation of the control function is small. Since the control input circuits and the corresponding semiconductor elements are connected via short bonding wires, noise is prevented from entering from the input side of the semiconductor elements and the module is protected from malfunction.

By arranging the semiconductor elements constituting the upper arm and the lower arm in the predetermined order, cross wiring of the conductors is prevented between the semiconductor elements and the input and output terminals of the main circuit. Thus, the chip mounting area of the base is utilized effectively and easy arrangement of the constituent elements is facilitated.

The chip mounting area is further reduced by disposing two sets of the common electrode plate and the individual electrode plates, one set for the upper arm semiconductor elements and another set for the lower arm semiconductor elements respectively, by arranging the upper arm semiconductor elements on the common electrode plate and connecting the upper arm semiconductor elements with the respective individual electrode plates, and by arranging the lower arm semiconductor elements on the respective individual electrode plates and connecting the lower arm semiconductor elements with the common electrode plate.

Manufacturing of the chips of the integrated control input circuit is facilitated by separating the semiconductor element chips from the control input circuit chips, and by mounting the control input circuit chips on electrode plates separate from the semiconductor element chips.

Further, application freedom of the driving circuit module is widened by including the power supply terminals led out from each control input terminal in the control input terminals.

## Claims

1. A driving circuit module comprising
a) a driving circuit device having a main circuit which includes semiconductor elements (10,10a) connected in a bridge circuit having upper and lower arms connected between a pair of power supply points (P,N);
b) control input circuits (20,20a) for controlling the respective semiconductor elements (10,10a);
c) a rectangular base plate (30);
d) input and output terminals (N,P) (U,V,W) of the main circuit connected with the corresponding semiconductor elements by respective conductors; and,
e) control input terminals (Tc) connected to their respective control input circuits (20,20a) via a wiring board or boards (50)
**characterised in that** chips are provided for the semiconductor elements (10) on the upper arms of the bridge circuit and chips are provided for the semiconductor elements (10a) on the lower arm of the bridge circuit and are each arranged in a row parallel with two opposed sides of the rectangular base (30), rows of chips of the control input circuits (20,20a) for the upper and lower arms of the bridge circuit are provided, each circuit (20,20a) being located in line with its respective semiconductor element (10,10a) in a direction normal to the row of semiconductor elements (10,10a), and in which the input terminals (P,N) and output terminals (U,V,W,) are arranged along one side or parallel sides of the base plate and the control input terminals (Tc) are arranged along one or more sides of the base plate not employed for the input and output terminals (P,N)(U,V,W).

2. A driving circuit module as claimed in claim 1 **characterised in that** said rectangular base plate (30) has two long and two shorter sides respective rows of chips for the semiconductor elements (10,10a) of the upper and lower arms being arranged in a single line.

3. A driving circuit module as claimed in claim 2 **characterised in that** the input and output terminals (N,P)(U,V,W,) are arranged along a long side of the base plate (30) adjacent the semiconductor elements (10,10a) and the control input terminals (Tc) are arranged along the other long side.

4. A driving circuit module as claimed in claim 1 **characterised in that** said rectangular base plate is square and the row of chips for the semiconductor elements (10) in the upper arm of the bridge circuit are arranged in a row parallel with the row of chips for the semiconductor elements (10a) in the lower arm of the bridge circuit, said rows being parallel with two of the sides of the square base plate (30).

5. A driving circuit module as claimed in claim 4 in which the input terminals (N,P) and output terminals (U,V,W) are arranged on opposite parallel sides of the base plate normal to the sides with which the rows semiconductor elements (10,10a) are parallel, and the central input terminals (Tc) are located along the other two sides of the square and parallel with the rows of semiconductor elements (10,10a) and adjacent the rows of chips of the central input circuits (20,20a).

6. The driving circuit module as claimed in any one of the preceding claims 1-5 **characterised by** a first common electrode plate (33); first individual electrode plates (34); a second common electrode plate (35); and second individual electrode plates (37), the semiconductor elements (10) constituting the upper arm of the main circuit being arranged on the first common electrode (33) plate and connected with the respective first individual electrode plates (34), and the semiconductor elements (10a) constituting the lower arm of the main circuit being arranged on the respective second individual electrode (37) plates and connected with the second common electrode plate (35).

7. The driving circuit module as claimed in claim 6 **characterised in that** the input terminals corresponding to the power supply points is connected with the first common electrode plate (33); the other input terminal is connected with the second common electrode plate (35); and the output terminals are connected in common with the respective first individual electrode plates (34) and the respective second individual electrode plates (37).

8. The driving circuit module as claimed in any one of the preceding claims 1 to 7 **characterised in that** the chips of the control input circuits are mounted on exclusive electrode plates (38) disposed on the base plate separately from chips of the semiconductor elements, and the control input circuits are connected with the corresponding semiconductor elements.

9. The driving circuit module as claimed in any one of the preceding claims 1 to 8 **characterised in that** the control input terminals include power supply terminals led out from the control input circuits.

10. The driving circuit module as claimed in any one of the preceding claims 1 to 9 **characterised by** comprising a case fitted to the base plate, the case being shaped with a frame having a window corresponding to the mounting area of the base plate, the semiconductor elements and the control input circuits being mounted therein.

## Patentansprüche

1. Treiberschaltungsmodul umfassend
a) eine Treiberschaltungsvorrichtung mit einer Hauptschaltung, die Halbleiterelemente (10, 10a) enthält, welche in einer Brückenschaltung angschlossen sind, welche obere und untere Arme hat, die zwischen einem Paar von Leistungsversorgungspunkten (P, N) verbunden sind;
b) Steuereingangsschaltungen (20, 20a) zum Steuern der jeweiligen Halbleiterelemente (10, 10a);
c) eine rechteckige Basisplatte (30);
d) Eingangs- und Ausgangsanschlüsse (N, P) (U, V, W) der Hauptschaltung, die mit den korrespondierenden Halbleiterelementen durch entsprechende Leitungen verbunden sind; und
e) Steuereingangsanschlüsse (Tc), welche mit ihren jeweiligen Steuereingangsschaltungen (20, 20a) über eine Verdrahtungsplatte oder - platten (50) verbunden sind
**dadurch gekennzeichnet, dass** Chips für die Halbleiterelemente (10) der oberen Arme der Brückenschaltung bereitgestellt sind und Chips für die Halbleiterelemente (10a) des unteren Arms der Brückenschaltung bereitgestellt sind und dass jedes in einer Zeile, die parallel zu zwei gegenüberliegenden Seiten der rechteckigen Basis (30) ist, angeordnet sind, Zeilen von Chips der Steuereingangsschaltungen (20, 20a) für den oberen und unteren Arm der Brückenschaltung sind bereitgestellt, jede Schaltung (20, 20a) ist in Linie mit seinem entsprechenden Halbleiterelement (10, 10a) in einer Richtung rechtwinklig zu der Zeile der Halbleiterelemente (10, 10a) angeordnet, und in welcher die Eingangsanschlüsse (P, N) und Ausgangsanschlüsse (U, V, W) entlang einer Seite oder paralleler Seiten der Basisplatte angeordnet sind und in der die Steuereingangsanschlüsse (Tc) entlang einer oder mehrerer Seiten der Basisplatte angeordnet sind, die nicht für die Eingangs- und Ausgangsanschlüsse (P, N) (U, V, W) verwendet werden.

2. Treiberschaltungsmodul nach Anspruch 1, **dadurch gekennzeichnet, dass** die rechteckige Basisplatte (30) zwei lange und zwei kürzere Seiten hat und dass die jeweiligen Zeilen von Chips für die Halbleiterelemente (10, 10a) der oberen und unteren Arme in einer einzelnen Linie angeordnet sind.

3. Treiberschaltungsmodul nach Anspruch 2, **dadurch gekennzeichnet, dass** die Eingangs- und Ausgangsanschlüsse (N, P) (U, V, W) entlang einer langen Seite der Basisplatte (30) benachbart der Halbleiterelemente (10, 10a) angeordnet sind und dass die Steuereingangsanschlüsse (Tc) entlang der anderen langen Seite angeordnet sind.

4. Treiberschaltungsmodul nach Anspruch 1, **dadurch gekennzeichnet, dass** die rechteckige Basisplatte quadratisch ist und die Zeile für Chips für die Halbleiterelemente (10) des oberen Arms der Brückenschaltung in einer Zeile parallel zu der Zeile der Chips für die Halbleiterelemente (10a) des unteren Arms der Brückenschaltung angeordnet ist, wobei die Zeilen parallel zu zwei Seiten der quadratischen Basisplatte (30) sind.

5. Treiberschaltungsmodul nach Anspruch 4 bei dem die Eingangsanschlüsse (N, P) und Ausgangsanschlüsse (U, V, W) auf gegenüberliegenden parallelen Seiten der Basisplatte rechtwinklig zu den Seiten, zu denen die Zeilen der Halbleiterbauelemente (10, 10a) parallel sind, angeordnet sind, und die zentralen Eingangsanschlüsse (Tc) sind entlang der anderen zwei Seiten des Quadrats und parallel zu den Zeilen der Halbleiterelemente (10, 10a) und benachbart der Zeilen der Chips der zentralen Eingangsschaltungen (20, 20a) angeordnet.

6. Treiberschaltungsmodul nach einem der vorangehenden Ansprüche 1 bis 5, **gekennzeichnet durch** eine erste gemeinsame Elektrodenplatte (33); erste individuelle Elektrodenplatten (34); eine zweite gemeinsame Elektrodenplatte (35); und zweite individuelle Elektrodenplatten (37), wobei die Halbleiterelemente (10), die den oberen Arm der Hauptschaltung bilden, auf der ersten gemeinsamen Elektrodenplatte (33) angeordnet sind und mit den jeweiligen ersten individuellen Elektrodenplatten (34) verbunden sind, und wobei die Halbleiterelemente (10a), die den unteren Arm der Hauptschaltung bilden, auf den jeweiligen zweiten individuellen Elektrodenplatten (37) angeordnet sind und mit der zweiten gemeinsamen Elektrodenplatte (35) verbunden sind.

7. Treiberschaltungsmodul nach Anspruch 6, **dadurch gekennzeichnet, dass** die zu den Leistungsversorgungspunkten korrespondierenden Eingangsanschlüsse mit der ersten gemeinsamen Elektrodenplatte (33) verbunden ist; der andere Eingangsanschluss ist mit der zweiten gemeinsamen Elektrodenplatte (35) verbunden; und die Ausgangsanschlüsse sind gemeinsam mit den jeweiligen ersten individuellen Elektrodenplatten (34) und den jeweiligen zweiten individuellen Elektrodenplatten (37) verbunden.

8. Treiberschaltungsmodul nach einem der vorangegangen Ansprüche 1 bis 7, **dadurch gekennzeichnet, dass** die Chips der Steuereingangsschaltung auf eigenen Elektrodenplatten (38), die auf der Basisplatte separat von den Chips der Halbleiterelemente angeordnet sind, angebracht sind, und die Steuereingangsschaltungen sind mit den korrespondierenden Halbleiterelementen verbunden.

9. Treiberschaltungsmodul nach einem der vorangegangen Ansprüche 1 bis 8, **dadurch gekennzeichnet, dass** die Steuereingangsanschlüsse Leistungsversorgungsanschlüsse enthalten, die aus den Steuereingangsschaltungen hinausleiten.

10. Treiberschaltungsmodul nach einem der vorangegangen Ansprüche 1 bis 9, **gekennzeichnet durch** Umfassen eines an die Basisplatte angepassten Gehäuses, das Gehäuse ist mit einem Rahmen geformt, der ein Fenster korrespondierend zu dem Befestigungsbereich der darin angebrachten Basisplatte, der Halbleiterelemente und der Steuereingangsschaltungen hat.

## Revendications

1. Module de circuit de commande, comprenant
a) un dispositif formant circuit de commande ayant un circuit principal qui comporte des éléments à semi-conducteurs (10, 10a) connectés dans un montage en pont ayant des branches supérieure et inférieure connectées entre deux points d'alimentation électrique (P, N) ;
b) des circuits d'entrée de commande (20, 20a) servant à commander les éléments à semi-conducteurs respectifs (10, 10a) ;
c) une plaque de base rectangulaire (30) ;
d) des bornes d'entrée et de sortie (N, P) (U, V, W) du circuit principal connectées aux éléments à semi-conducteurs correspondants par des conducteurs respectifs ; et
e) des bornes d'entrée de commande (Tc) connectées à leurs circuits d'entrée de commande respectifs (20, 20a) par l'intermédiaire d'une ou de plusieurs plaquettes de connexion (50)
**caractérisé en ce que** des puces sont prévues pour les éléments à semi-conducteurs (10) sur la branche supérieure du montage en pont et des puces sont prévues pour les éléments à semi-conducteurs (10a) sur la branche inférieure du montage en pont et sont disposées chacune en une rangée parallèle à deux côtés opposés de la base rectangulaire (30), des rangées de puces des circuits d'entrée de commande (20, 20a) pour les branches supérieure et inférieure du montage en pont sont prévues, chaque circuit (20, 20a) étant aligné par rapport à son élément à semi-conducteurs respectif (10, 10a) dans une direction perpendiculaire à la rangée d'éléments à semi-conducteurs (10, 10a), et dans lequel les bornes d'entrée (P, N) et les bornes de sortie (U, V, W) sont disposées sur un seul côté ou sur des côtés parallèles de la plaque de base et les bornes d'entrée de commande (Tc) sont disposées sur un ou plusieurs côtés de la plaque de base non utilisés pour les bornes d'entrée et de sortie (P, N) (U, V, W).

2. Module de circuit de commande selon la revendication 1, **caractérisé en ce que** ladite plaque de base rectangulaire (30) comporte deux rangées latérales respectives longues et deux rangées latérales respectives courtes de puces pour les éléments à semi-conducteurs (10, 10a) des branches supérieure et inférieure disposées sur une seule ligne.

3. Module de circuit de commande selon la revendication 2, **caractérisé en ce que** les bornes d'entrée et de sortie (N, P) (U, V, W) sont disposées sur un grand côté de la plaque de base (30) adjacent aux éléments à semi-conducteurs (10, 10a) et les bornes d'entrée de commande (Tc) sont disposées sur l'autre grand côté.

4. Module de circuit de commande selon la revendication 1, **caractérisé en ce que** ladite plaque de base rectangulaire est carrée et les puces pour les éléments à semi-conducteurs (10) de la branche supérieure du montage en pont sont disposées en une rangée parallèle à la rangée de puces pour les éléments à semi-conducteurs (10a) de la branche inférieure du montage en pont, lesdites rangées étant parallèles à deux des côtés de la plaque de base carrée (30).

5. Module de circuit de commande selon la revendication 4, dans lequel les bornes d'entrée (N, P) et les bornes de sortie (U, V, W) sont disposées sur des côtés opposés parallèles de la plaque de base perpendiculairement aux côtés auxquels les rangées d'éléments à semi-conducteurs (10, 10a) sont parallèles, et les bornes d'entrée centrales (Tc) sont situées le long des deux autres côtés du carré et parallèles aux rangées d'éléments à semi-conducteurs (10, 10a) et au voisinage immédiat des rangées de puces des circuits d'entrée centraux (20, 20a).

6. Module de circuit de commande selon l'une quelconque des revendications 1 à 5 précédentes, **caractérisé par** une première plaque électrode commune (33) ; des premières plaques électrodes individuelles (34) ; une deuxième plaque électrode commune (35) et des deuxièmes plaques électrodes individuelles (37), les éléments à semi-conducteurs (10) qui constituent la branche supérieure du circuit principal étant disposés sur la première plaque électrode commune (33) et connectés aux premières plaques électrodes individuelles (34), et les éléments à semi-conducteurs (10a) qui constituent la branche inférieure du circuit principal étant disposés sur les deuxièmes plaques électrodes individuelles respectives (37) et connectés à la deuxième plaque électrode commune (35).

7. Module de circuit de commande selon la revendication 6, **caractérisé en ce que** les bornes d'entrée correspondant aux points d'alimentation électrique sont connectées à la première plaque électrode commune (33) ; l'autre borne d'entrée est connectée à la deuxième plaque électrode commune (35) ; et les bornes de sortie sont connectées en commun aux premières plaques électrodes individuelles respectives (34) et aux deuxièmes plaques électrodes individuelles respectives (37).

8. Module de circuit de commande selon l'une quelconque des revendications précédentes 1 à 7, **caractérisé en ce que** les puces des circuits d'entrée de commande sont montées sur des plaques électrodes exclusives (38) disposées sur la plaque de base séparément des puces des éléments à semi-conducteurs, et les circuits d'entrée de commande sont connectés aux éléments à semi-conducteurs correspondants.

9. Module de circuit de commande selon l'une quelconque des revendications précédentes 1 à 8, **caractérisé en ce que** les bornes d'entrée de commande comportent des bornes d'alimentation électrique à l'écart des circuits d'entrée de commande.

10. Module de circuit de commande selon l'une quelconque des revendications 1 à 9 précédentes, **caractérisé en ce qu'**il comprend un boîtier installé sur la plaque de base, le boîtier étant pourvu d'un cadre avec une fenêtre correspondant à la zone de montage de la plaque de base, les éléments à semi-conducteurs et les circuits d'entrée de commande étant montés dans celle-ci.
